# EUROPEAN PATENT APPLICATION

(11) **EP 2 258 772 A1**
(43) Date of publication of application: **08.12.2010**
(21) Application number: 10164954.9
(22) Date of filing: 04.06.2010
(51) Int. Cl.: C08L 63/00

(54) **Epoxy Resin Composition for Semiconductor Encapsulation and Semiconductor Device Using the Same**

(30) Priority: 04.06.2009 JP 2009134899
(71) Applicant: NITTO DENKO CORPORATION, Osaka (JP)
(72) Inventor: Akizuki, Shinya, Osaka-shi Osaka (JP); Ishizaka, Tsuyoshi, Osaka-shi Osaka (JP); Tabuchi, Yasuko, Osaka-shi Osaka (JP); Ichikawa, Tomoaki, Osaka-shi Osaka (JP)
(74) Representative: Grünecker, Kinkeldey, Stockmair & Schwanhäusser Anwaltssozietät

(57) **Abstract**

The present invention relates to an epoxy resin composition for semiconductor encapsulation, which includes the following components (A) to (E): (A) a bifunctional epoxy resin, (B) a curing agent, (C) an imidazole compound represented by the formula (1), in which R¹ and R² each independently represent an alkyl group or an alkylol group, in which at least one of R¹ and R² represents an alkylol group, and R³ represents an alkyl group or an aryl group, (D) a linear saturated carboxylic acid having a number average molecular weight of 550 to 800, and (E) an inorganic filler.

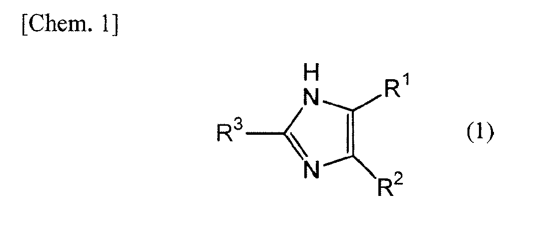

## Description

### FIELD OF THE INVENTION

The present invention relates to an epoxy resin composition for semiconductor encapsulation and a semiconductor device using the same.

### BACKGROUND OF THE INVENTION

In the process of producing a semiconductor device, a semiconductor element after the completion of bonding to a substrate is generally encapsulated using a molding resin such as thermosetting resin for avoiding contact with the outside. Examples of the molding resin used for this purpose include a resin obtained by mixing and dispersing an inorganic filler mainly composed of silica particle in an epoxy resin. As regards the encapsulation method using this molding resin, for example, a transfer molding method including placing a semiconductor element bonded to a substrate in a metal mold, pressure-feeding the molding resin thereinto, and curing and shaping the molding resin is practically used.

Conventionally, a resin-encapsulation-type semiconductor device obtained by encapsulating a semiconductor element with a molding resin is excellent in terms of reliability, mass productivity, cost and the like and is spread as well as a ceramic-encapsulation-type semiconductor device employing ceramic as a constituent material.
With recent reduction in the thickness and growth in the size of a semiconductor device, in a semiconductor device having a one-side encapsulated structure such as ball grid array (BGA) in which a semiconductor element is connected to a substrate by a metal wire, the resin flow part at the encapsulation with a resin is becoming narrow. Accordingly, flowability of the resin is reduced to easily allow inclusion of a void and, as a result, there arises a problem such as deformation of the metal wire. Therefore, studies have been made to improve the flowability (see, Patent Document 1).
Also, enlargement of the encapsulation area resulting from reduction in the thickness and growth in the size of a semiconductor device involves an increase of the adhesion area between an encapsulating resin layer and a polyimide material conventionally used as a protective film for the semiconductor device surface, and the adhesiveness is also demanded.

Patent Document 1: JP-A-11-106476 (the term "JP-A" as used herein means an "unexamined published Japanese patent application")

### SUMMARY OF THE INVENTION

An object of the present invention is to provide a resin composition for semiconductor encapsulation, which is excellent in flowability, adhesiveness to a polyimide material and continuous moldability, and a semiconductor device using the same.

The present invention provides an epoxy resin composition for semiconductor encapsulation, which contains the following components (A) to (E):
- (A): a bifunctional epoxy resin,
- (B): a curing agent,
- (C): an imidazole compound represented by the formula (1):

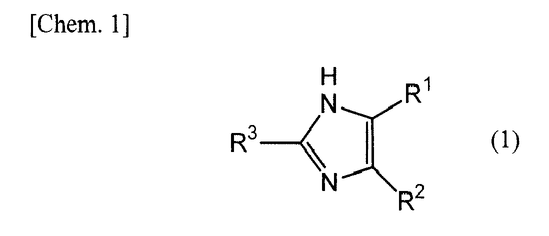

(wherein R¹ and R² each independently represent an alkyl group or an alkylol group, in which at least one of R¹ and R² represents an alkylol group, and R³ represents an alkyl group or an aryl group),
(D) a linear saturated carboxylic acid having a number average molecular weight of 550 to 800, and
(E) an inorganic filler;
   and a semiconductor device using the same.

With an aim to balance the wire sway and the continuous moldability by the reduction of viscosity, which is a prerequisite, the present inventors have made a series of studies to obtain an epoxy resin composition capable of working out to an excellent encapsulant imparted with an adhesive force to a polyimide material to which adhesive force is heretofore seriously reduced. As a result, it has been found that when the above-described specific curing accelerator, a specific mold release agent and a bifunctional epoxy resin as a low-viscosity resin are used, not only excellent continuous moldability is imparted but also the adhesiveness to a polyimide material is improved. The present invention has been accomplished based on this finding.

According to the present invention, a composition containing components (A) to (E), particularly a bifunctional epoxy resin as the component (A), a component (C) having a curing accelerating function and a component (D) having a mold release function, is used, whereby a resin composition for semiconductor encapsulation, which is excellent in flowability, adhesiveness to a polyimide material and continuous moldability, and a semiconductor device using the same can be provided. Also, according to the present invention, since high adhesiveness and good flame retardance are ensured, excellent reflow resistance is expected to be achieved.

### DETAILED DESCRIPTION OF THE INVENTION

The constituent elements of the epoxy resin composition for semiconductor encapsulation of the present invention (hereinafter sometimes referred to as "the composition of the present invention") are described below. Incidentally, it should be noted that in the present specification, all parts, percentages, and ratios defined by mass are the same as those defined by weight, respectively.
The component (A) is described below.
The component (A) is a bifunctional epoxy resin and is preferably a compound represented by the following formula (2) (hereinafter sometimes referred to as a "compound (2)"; the same applies to others).

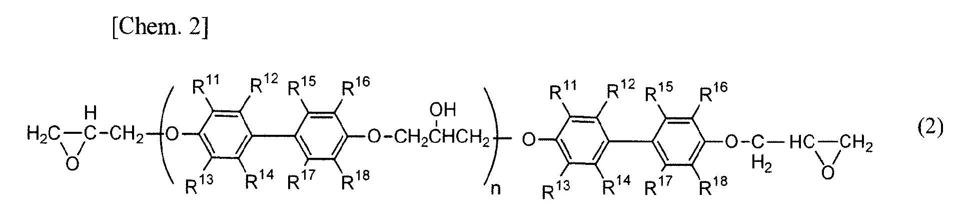

(wherein R¹¹ to R¹⁸ each independently are selected from a hydrogen atom and a substituted or unsubstituted monovalent hydrocarbon group having a carbon number of 1 to 10, and n represents an integer of 0 to 3).
In the compound (2), the hydrocarbon group may be saturated or unsaturated and may be linear, branched or cyclic but is preferably a methyl group or an ethyl group.

The compound (2) is preferably used alone but may be used in combination with a general epoxy resin differing in the structure. Examples of such a resin which can be used include various epoxy resins such as those of dicyclopentadiene type, cresol novolak type, phenol novolak type, bisphenol type, biphenyl type and tris(hydroxyphenyl)methane type. However, the component (A) is preferably blended to occupy 60 mass% or more in the epoxy resin components.
In particular, when the component (A) is combined with the component (C) having a specific structure, flame retardance and adhesiveness to a polyimide material can be ensured.

The component (B) is described below.
The component (B) acts as a curing agent for the component (A) and is not particularly limited, and examples thereof include a dicyclopentadiene-type phenol resin, a phenol novolak resin, a cresol novolak resin, a phenol aralkyl resin and a biphenyl skeleton-containing phenol novolak resin.
One of these phenol resins may be used alone, or two or more thereof may be used in combination. In view of flame retardance, a compound represented by the following formula (3) or (4) is preferred.

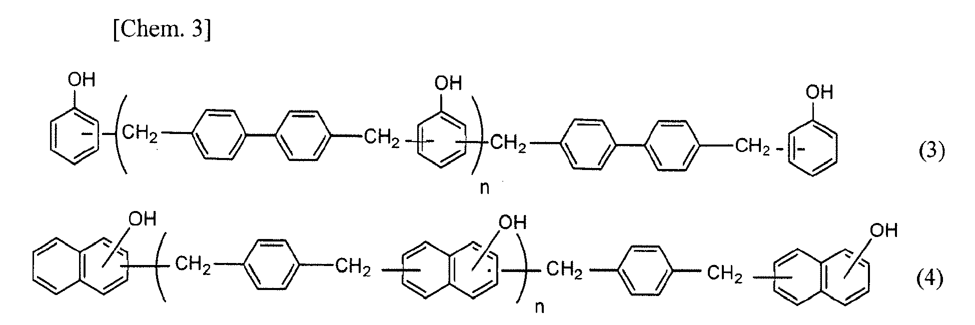

In formula (3) or (4), each n independently represents an integer of 0 to 5, preferably from 0 to 2.

The blending ratio of the component (B) to the component (A) is preferably set to an amount sufficiently large to cure the component (A). The component (B) is preferably blended such that the total of hydroxyl groups therein becomes from 0.6 to 1.2 equivalents, more preferably from 0.7 to 1.0 equivalents, per equivalent of epoxy group in the component (A).

As for the component (C) used together with the components (A) and (B), the above-described compound (1) is used as a curing accelerator.
In the compound (1), the alkyl group of R¹ or R² preferably has a carbon number of 1 to 5, more preferably from 1 to 2. The alkylol group of R¹ or R² preferably has a carbon number of 1 to 5, more preferably from 1 to 2. The alkyl group of R³ preferably has a carbon number of 1 to 5, more preferably from 1 to 2. The aryl group of R³ preferably has a carbon number of 6 to 12, more preferably 6.
In view of easy availability and flame retardance, 2-phenyl-4-methyl-5-hydroxymethylimidazole represented by the formula (1-1) and 2-phenyl-4,5-di(hydroxymethy)limidazole (a curing accelerator G described later) are preferred, and in view of flowability, 2-phenyl-4-methyl-5-hydroxymethylimidazole represented by the formula (1-1) is more preferred.

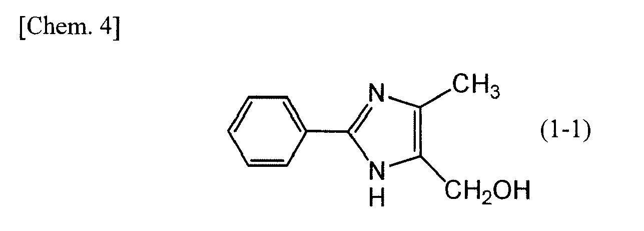

The compound (1) may be used alone but may be used in combination with conventionally known various curing accelerators. For example, the compound (1) and one or more kinds of curing accelerators selected from an organophosphorus-based compound such as tetraphenylphosphonium tetraphenylborate and triphenylphosphine, and a diazabicycloalkene-based compound such as 1,8-Diazabicyclo[5.4.0]undec-7-ene and 1,5-Diazabicyclo[4.3.0]non-5-ene may be used in combination. In this case, the amount of the compound (1) used is preferably at least 3 mass% based on the component (B), and the upper limit thereof is preferably about 20 mass%. Also, the compound (1) is preferably used in an amount of 4 mass% or more based on the entire curing accelerator. Within the above-mentioned range, flame retardance, flowability and adhesiveness to a polyimide material are ensured and the above-described effects of the present invention are more effectively brought out.

The component (D) is described below.
The component (D) is a mold release agent and is a linear saturated carboxylic acid having a number average molecular weight of 550 to 800, preferably from 600 to 800. The component (D) can be represented by formula (5) wherein n may be the same or different and is selected to satisfy the above-described number average molecular weight. Incidentally, those having a number average molecular weight of 800 or more are hardly available at present, and the performance thereof is not verified.

CH₃-(CH₂)ₙ-COOH (5)

The component (D) is used for ensuring the continuous moldability of the composition of the present invention.
The content of the component (D) is preferably from 0.05 to 1.5 mass%, more preferably from 0.1 to 0.8 mass%, still more preferably from 0.1 to 0.4 mass%, based on the composition of the present invention. Within the above-mentioned range, the continuous moldability can be more unfailingly ensured while maintaining the flame retardance, flowability and adhesiveness.
In the composition of the present invention, the component (D) may be used in combination with a general mold release agent. Examples of such a general mold release agent include compounds such as higher fatty acid ester and higher fatty acid calcium, and for example, a carnauba wax or a polyethylene-based wax may be used. One or more kinds these mold release agents may also be used in combination with the component (D).

Examples of the material for the inorganic filler as the component (E) include quartz glass powder, talc, silica powder (e.g., fused silica powder, crystalline silica powder), alumina powder, aluminum nitride powder and silicon nitride powder. One of these may be used alone, or two or more thereof may be used in combination. Above all, silica powder is preferably used because the linear expansion coefficient of the cured product obtained can be reduced. Among silica powders, fused spherical silica powder is preferred from the standpoint of maintaining the effects of the present invention as well as in view of high filling property and high flowability.
The content of the component (E) is from 60 to 93 mass%, preferably from 70 to 91 mass%, based on the composition of the present invention.

In the composition of the present invention, in addition to the above-described components, other additives such as silane coupling agent, flame retardant, ion trapping agent, pigment or colorant (e.g., carbon black), and stress reducing agent, may be appropriately blended.

The silane coupling agent is not particularly limited, and various silane coupling agents may be used. Above all, a silane coupling agent having two or more alkoxy groups is suitably used. Specific examples thereof include β-(3,4-epoxycyclohexyl)ethyltrimethoxysilane, γ-glycidoxypropyltrimethoxysilane, γ-mercaptopropyltrimethoxysilane, γ-[(2-aminoethyl)amino]propyltrimethoxysilane, γ-mercaptopropyldimethoxysilane, γ-anilinopropyltrimethoxysilane and hexamethyldisilazane. One of these may be used alone, or two or more thereof may be used in combination.

Examples of the flame retardant include a novolak-type brominated epoxy resin and a metal hydroxide.

As for the ion trapping agent, all known compounds having an ion trapping ability can be used, and examples thereof include hydrotalcites and bismuth hydroxide.

Examples of the stress reducing agent include a butadiene-based rubber such as methyl acrylate-butadiene-styrene copolymer and methyl methacrylate-butadiene-styrene copolymer, and a silicone compound.

The composition of the present invention can be produced, for example, as follows. That is, the components (A) to (E) and, if desired, other additives are appropriately blended in a usual manner and melt-kneaded under heating by using a kneader such as mixing roll, and the kneaded product is cooled and solidified at room temperature. Thereafter, a series of steps, that is, pulverization by a known technique and, if desired, tabletting, are performed, whereby the objective composition of the present invention can be produced.

Encapsulation of a semiconductor element by using the thus-obtained composition of the present invention is not particularly limited but may be performed by a known molding method such as normal transfer molding.
Also, without passing through a tabletting step, the powder in a granular state may be applied to a molding method of compress molding.

The semiconductor device obtained in this way has good wire sway and good mold releasability by virtue of control of the above-described specific epoxy resin, curing agent, curing accelerator and mold release agent in the composition of the present invention. Furthermore, the semiconductor device has excellent reliability in terms of reflow resistance owing to improvement of adhesiveness to a polyimide material.

### EXAMPLES

Examples are described below together with Comparative Examples.
First, the components shown below were prepared.

### Epoxy Resin A

YX-4000H produced by Japan Epoxy Resins Co., Ltd. (epoxy equivalent: 195, melting point: 107°C, having the basic structure of the compound (2), within the scope of the present invention).

### Epoxy Resin B

YDC-1312 produced by Tohto Kasei Co., Ltd. (epoxy equivalent: 175, melting point: 145°C, having the following structure, within the scope of the present invention).

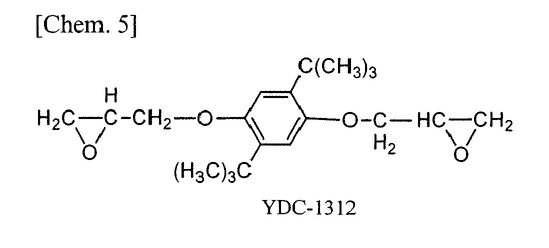

### Epoxy Resin C

KI-5000 produced by Nippon Kayaku Co., Ltd. (epoxy equivalent: 195, melting point: 67°C, having the following structure, for comparison).

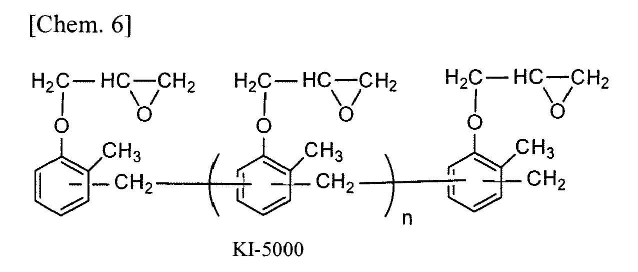

### Phenol Resin D

MEH-7851 produced by Meiwa Plastic Industries, Ltd. (hydroxyl group equivalent: 210, softening point: 73°C, the above-described compound (3), within the scope of the present invention).

### Phenol Resin E

SN-160L produced by Tohto Kasei Co., Ltd. (hydroxyl group equivalent: 176, softening point: 59°C, the above-described compound (4), within the scope of the present invention).

### Phenol Resin F

XLC-3L produced by Mitsui Chemicals, Inc. (hydroxyl group equivalent: 170, softening point: 67°C, having the following structure, within the scope of the present invention).

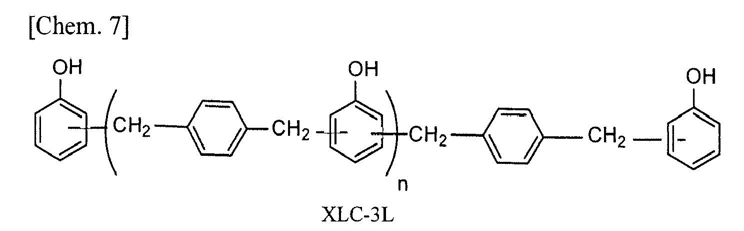

### Curing Accelerator G

2PHZ produced by Shikoku Chemicals Corporation (having the following structure, within the scope of the present invention).

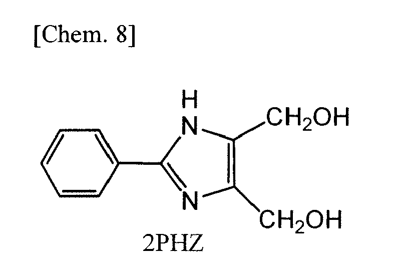

### Curing Accelerator H

2P4MHZ-PW produced by Shikoku Chemicals Corporation (the above-mentioned compound (1-1), within the scope of the present invention).

### Curing Accelerator I

C11ZA produced by Shikoku Chemicals Corporation (having the following structure, for comparison).

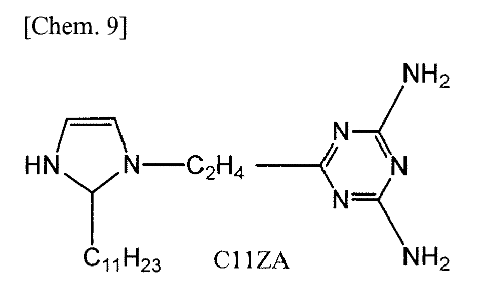

### Curing Accelerator J

Triphenylphosphine TPP (having the following structure, for comparison).

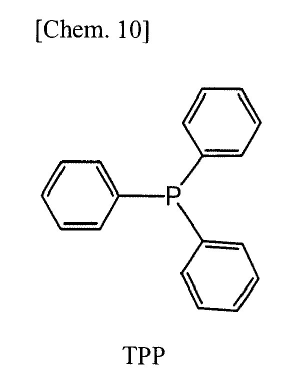

### Mold Release Agent K

Unicid (registered trademark)-700 produced by Baker Petrolite Corporation (number average molecular weight: 789, having the following structure, within the scope of the present invention).

CH₃CH₂-(CH₂CH₂)ₙ-COOH n (average)=24

### Mold Release Agent L

Unicid (registered trademark)-550 produced by Baker Petrolite Corporation (number average molecular weight: 553, having the following structure, within the scope of the present invention).

CH₃CH₂-(CH₂CH₂)ₙ-COOH n (average)=19

### Mold Release Agent M

Unicid (registered trademark)-350 produced by Baker Petrolite Corporation (number average molecular weight: 372, having the following structure, for comparison).

CH₃-(CH₂)ₙ-COOH n (average)=24

### Mold Release Agent N

PED-521 produced by Clariant (polyethylene oxide, for comparison).

### Inorganic Filler

FB-570 produced by Denki Kagaku Kogyo Kabushiki Kaisha (spherical fused silica powder (average particle diameter: 16.2 µm), within the scope of the present invention).

### Examples 1 to 16 and Comparative Examples 1 to 28:

Raw materials (parts by mass) shown in Tables 1 to 3 below were blended all together in a ratio shown in the Tables and melt-kneaded by a mixing roll (temperature: 100°C) for 3 minutes. Subsequently, the melt was cooled, then pulverized and further tabletted to obtain the objective epoxy resin composition for semiconductor encapsulation (hereinafter sometimes referred to as the "composition").
The obtained composition was evaluated as follows, and the results are shown in the same Tables.

### 1) Flowability:

### 1a) SF (cm), GT (sec)

### Spiral Flow (SF)

A spiral flow value (cm) was measured in accordance with the method of EMMI 1-66 under the conditions of 175±5°C, 120 seconds and 70 kg/cm² by using a mold for spiral flow measurement.

### Gelling Time (GT)

From about 200 to 500 mg of the composition was put on a hot plate at 175°C, and the time spent until stringing of the resin under stirring with a glass bar of 1.5 mm in diameter was not observed was defined as the gelling time (sec).

### 1b) Wire Sway

A package was encapsulated by transfer molding (molding temperature: 175°C, molding time 90 sec) with the composition obtained in each Examples and Comparative Examples, followed by post curing at 175°C for 5 hours to obtain a semiconductor device. In this regard, the package used was prepared by wire bonding a semiconductor element (size: 10 mm × 10 mm × thickness 0.3 mm) to a ball grid array (BGA) substrate (size: 35 mm × 35 mm × thickness 0.5 mm) with a gold wire (diameter 0.02 mm x length 4.5 mm). The condition of the gold wire of the semiconductor device thus obtained was observed using a X-ray analyzer, thereby obtaining the average value of wire sway of 30 pieces of semiconductor devices.

### 2) Adhesive Force to Polyimide Material

A semiconductor element (10 mm x 10 mm x 0.52 mm) coated with a photosensitive polyimide (I8320, produced by Asahi Kasei EMD Corporation) was prepared. A cylindrical molded article having an adhesion area of 10 mm² with the element surface of the semiconductor element was produced by transfer molding (molding temperature: 175°C, molding time 90 sec) using the composition obtained in each Examples and Comparative Examples, followed by post curing at 175°C for 5 hours. The shear adhesive force was measured using the obtained molded article by applying a power with push pull gauge from the horizontal direction of the semiconductor element at 260°C.

### 3) Continuous Moldability

The mold used in 1b) was previously cleaned, the package of b) was then repeatedly encapsulated by transfer molding (molding temperature: 175°C, molding time 14 sec) using the composition obtained in each of Examples and Comparative Examples, and the number of shots until the composition sticks to the mold (sticking) or forms stain on the mold was measured.

### 4) Flame Retardance

A specimen of 1/32 inch in thickness and 10 mm in width was produced using the composition obtained in each of Examples and Comparative Examples with the molding conditions of molding at 175°C for 2 min and post curing at 175°C for 5 hours. Flame retardance of the specimen obtained was evaluated in accordance with UL94 V-0.
The specimen was rated A when the total flaming time of N=5 was 40 seconds or less, rated B when from 41 to 60 seconds, and rated C when 61 seconds or more.

**Table 1**

| | | Example | | | | | | | | | | | | | | | |
|---|---|---|---|---|---|---|---|---|---|---|---|---|---|---|---|---|---|
| Component | | 1 | 2 | 3 | 4 | 5 | 6 | 7 | 8 | 9 | 10 | 11 | 12 | 13 | 14 | 15 | 16 |
| (A) | Epoxy resin A | 196 | 196 | 196 | 196 | | | | | 196 | 196 | 196 | 196 | 196 | 196 | 196 | 196 |
| | Epoxy resin B | | | | | 176 | 176 | 176 | 176 | | | | | | | | |
| | Epoxy resin C | | | | | | | | | | | | | | | | |
| (B) | Phenol resin D | 210 | 210 | | | 210 | 210 | | | | | 210 | | 210 | 210 | 210 | 210 |
| | Phenol resin E | | | 176 | 176 | | | 176 | 176 | | | | 176 | | | | |
| | Phenol resin F | | | | | | | | | 170 | 170 | | | | | | |
| (C) | Curing accelerator G | 14.7 | | 12.3 | | 14.7 | | 12.3 | | 11.9 | 11.9 | 14.7 | 12.3 | 14.7 | 14.7 | 14.7 | 14.7 |
| | Curing accelerator H | | 14.7 | | 12.3 | | 14.7 | | 12.3 | | | | | | | | |
| | Curing accelerator I | | | | | | | | | | | | | | | | |
| | Curing accelerator J | | | | | | | | | | | | | | | | |
| (D) | Mold release agent K | 10.5 | 10.5 | 9.61 | 9.61 | 10 | 10 | 9.11 | 9.11 | 9.45 | | | | 3.51 | 17.5 | 1.8 | 32 |
| | Mold release agent L | | | | | | | | | | 9.45 | 10.5 | 9.61 | | | | |
| | Mold release agent M | | | | | | | | | | | | | | | | |
| | Mold release agent N | | | | | | | | | | | | | | | | |
| (E) | Inorganic filler | 3085 | 3085 | 2818 | 2818 | 2938 | 2938 | 2672 | 2672 | 2771 | 2771 | 3085 | 2818 | 3085 | 3085 | 3085 | 3085 |
| | total | 3516 | 3516 | 3212 | 3212 | 3349 | 3349 | 3045 | 3045 | 3158 | 3158 | 3516 | 3212 | 3509 | 3523 | 3508 | 3538 |
| | Amount of component (D) (mass%) | 0.3 | 0.3 | 0.3 | 0.3 | 0.3 | 0.3 | 0.3 | 0.3 | 0.3 | 0.3 | 0.3 | 0.3 | 0.1 | 0.5 | 0.05 | 0.90 |
| | SF (cm) | 198 | 195 | 197 | 195 | 196 | 199 | 196 | 196 | 189 | 194 | 198 | 189 | 189 | 215 | 184 | 221 |
| | GT (sec) | 38 | 37 | 37 | 38 | 39 | 37 | 39 | 39 | 39 | 40 | 38 | 38 | 38 | 40 | 39 | 41 |
| | Wire sway (%) | 1.8 | 1.7 | 1.4 | 1.3 | 1.7 | 1.5 | 1.7 | 1.6 | 1.4 | 1.3 | 1.4 | 1.5 | 1.8 | 1.2 | 1.8 | 1 |
| | Adhesive force to photosensitive polyimide (kg/mm²) | 5.7 | 5.6 | 5.5 | 5.6 | 5.7 | 5.8 | 5.7 | 5.7 | 5.5 | 5.4 | 5.4 | 5.3 | 5.7 | 5.7 | 5.7 | 5.6 |
| | Continuous moldability (number of shots until | > | > | > | > | > | > | > | > | > | 445 | 437 | 475 | > | > | 231 | > |
| | occurrence of sticking) | 500 | 500 | 500 | 500 | 500 | 500 | 500 | 500 | 500 | | | | 500 | 500 | | 500 |
| | Continuous moldability (number of shots until stain | > | > | > | > | > | > | > | > | > | > | > | > | > | 412 | > | 102 |
| | formation) | 500 | 500 | 500 | 500 | 500 | 500 | 500 | 500 | 500 | 500 | 500 | 500 | 500 | | 231 | |
| | Flame retardance | A | A | A | A | B | B | B | B | B | B | A | A | A | A | A | A |

**Table 2**

| | | Comparative Example | | | | | | | | | | | |
|---|---|---|---|---|---|---|---|---|---|---|---|---|---|
| Component | | 1 | 2 | 3 | 4 | 5 | 6 | 7 | 8 | 9 | 10 | 11 | 12 |
| (A) | Epoxy resin A | 196 | 196 | 196 | 196 | 196 | 196 | | | | | | |
| | Epoxy resin B | | | | | | | 176 | 176 | 176 | | | |
| | Epoxy resin C | | | | | | | | | | 196 | 196 | 196 |
| (B) | Phenol resin D | 210 | 210 | | | | | 210 | | | 210 | | |
| | Phenol resin E | | | 176 | 176 | | | | 176 | | | 176 | |
| | Phenol resin F | | | | | 170 | 170 | | | 170 | | | 170 |
| (C) | Curing accelerator G | | | | | | | | | | | | |
| | Curing accelerator H | | | | | | | | | | | | |
| | Curing accelerator I | 14.7 | | 12.3 | | 11.9 | | 10.5 | 8.8 | 8.5 | 14.7 | 12.3 | 11.9 |
| | Curing accelerator J | | 8.4 | | 7.04 | | 6.8 | | | | | | |
| (D) | Mold release agent K | | | | | | | | | | | | |
| | Mold release agent L | | | | | | | | | | | | |
| | Mold release agent M | | | | | | | | | | | | |
| | Mold release agent N | 10.5 | 10.4 | 9.6 | 9.5 | 9.4 | 9.3 | 9.9 | 9.0 | 8.9 | 10.3 | 9.4 | 9.3 |
| (E) | Inorganic filler | 3085 | 3039 | 2818 | 2780 | 2771 | 2734 | 2908 | 2646 | 2600 | 3015 | 2754 | 2708 |
| | Total | 3516 | 3464 | 3212 | 3169 | 3158 | 3116 | 3314 | 3016 | 2963 | 3446 | 3148 | 3095 |
| | Amount of component (D) (mass%) | 0.3 | 0.3 | 0.3 | 0.3 | 0.3 | 0.3 | 0.3 | 0.3 | 0.3 | 0.3 | 0.3 | 0.3 |
| | SF (cm) | 156 | 165 | 165 | 163 | 149 | 156 | 167 | 174 | 167 | 124 | 149 | 145 |
| | GT (sec) | 35 | 34 | 34 | 34 | 33 | 34 | 31 | 30 | 29 | 31 | 32 | 34 |
| | Wire sway (%) | 4.5 | 4.4 | 4.4 | 4.4 | 4.6 | 4.5 | 3.9 | 4 | 3.8 | 7.8 | 7.6 | 7.7 |
| | Adhesive force to photosensitive polyimide (kg/mm²) | 1.5 | 1.2 | 1.3 | 1.4 | 1.4 | 1.3 | 1.2 | 1.3 | 1.1 | 6.3 | 5.7 | 5.6 |
| | Continuous moldability (number of shots until | > | > | > | > | > | > | > | > | > | > | > | > |
| | occurrence of sticking) | 500 | 500 | 500 | 500 | 500 | 500 | 500 | 500 | 500 | 500 | 500 | 500 |
| | Continuous moldability (number of shots until stain | > | > | > | > | > | > | > | > | > | > | > | > |
| | formation) | 500 | 500 | 500 | 500 | 500 | 500 | 500 | 500 | 500 | 500 | 500 | 500 |
| | Flame retardance | A | A | A | A | B | B | C | C | C | C | C | C |

**Table 3**

| | | Example | | | | | | | | | | | | | | | |
|---|---|---|---|---|---|---|---|---|---|---|---|---|---|---|---|---|---|
| Component | | 13 | 14 | 15 | 16 | 17 | 18 | 19 | 20 | 21 | 22 | 23 | 24 | 25 | 26 | 27 | 28 |
| (A) | Epoxy resin A | 196 | 196 | 196 | 196 | 196 | 196 | | | | | | | 196 | 196 | | |
| | Epoxy resin B | | | | | | | 176 | 176 | 176 | | | | | | | |
| | Epoxy resin C | | | | | | | | | | 196 | 196 | 196 | | | 196 | 196 |
| (B) | Phenol resin D | 210 | 210 | | | | | 210 | | | 210 | | | 210 | 210 | 210 | 210 |
| | Phenol resin E | | | 176 | 176 | | | | 176 | | | 176 | | | | | |
| | Phenol resin F | | | | | 170 | 170 | | | 170 | | | 170 | | | | |
| (C) | Curing accelerator G | | | | | | | | | | | | | 14.7 | 14.7 | 14.7 | 14.7 |
| | Curing accelerator H | | | | | | | | | | | | | | | | |
| | Curing accelerator I | 14.7 | 14.7 | 12.3 | 12.3 | 11.9 | 11.9 | 10.5 | 8.8 | 8.5 | 14.7 | 12.3 | 11.9 | | | | |
| | Curing accelerator J | | | | | | | | | | | | | | | | |
| (D) | Mold release agent K | | | | | | | | | | | | | | | 10.31 | |
| | Mold release agent L | 1.3 | | 1.2 | | 1.1 | | 1.2 | 1.1 | 1.1 | 1.3 | 1.2 | 1.2 | | | | 10.31 |
| | Mold release agent M | | 1.3 | | 1.2 | | 1.1 | | | | | | | 1.3 | | | |
| | Mold release agent N | | | | | | | | | | | | | | 10.3 | | |
| (E) | Inorganic filler | 3085 | 3085 | 2818 | 2818 | 2771 | 2771 | 2908 | 2646 | 2600 | 3015 | 2754 | 2708 | 3015 | 3015 | 3015 | 3015 |
| | Total | 3507 | 3507 | 3204 | 3204 | 3150 | 3150 | 3306 | 3008 | 2956 | 3437 | 3140 | 3087 | 3437 | 3446 | 3446 | 3446 |
| | Amount of component (D) (mass%) | 0.04 | 0.00 | 0.04 | 0.00 | 0.03 | 0.00 | 0.04 | 0.04 | 0.04 | 0.04 | 0.04 | 0.04 | 0.00 | 0.00 | 0.299 | 0.299 |
| | SF (cm) | 189 | 187 | 187 | 189 | 191 | 186 | 167 | 174 | 167 | 126 | 132 | 123 | 193 | 154 | 134 | 126 |
| | GT (sec) | 39 | 38 | 40 | 41 | 38 | 39 | 38 | 37 | 38 | 31 | 32 | 34 | 40 | 38 | 37 | 36 |
| | Wire sway (%) | 1.7 | 1.8 | 1.5 | 1.6 | 1.5 | 1.6 | 1.4 | 1.3 | 1.4 | 3.5 | 3.7 | 3.6 | 1.7 | 4.3 | 6.5 | 5.8 |
| | Adhesive force to photosensitive polyimide (kg/mm²) | 1.4 | 1.2 | 1.4 | 1.3 | 1.5 | 1.4 | 1.3 | 1.4 | 1.4 | 5.4 | 5.2 | 5.2 | 5.2 | 5.2 | 6.1 | 6.2 |
| | Continuous moldability (number of shots until occurrence of sticking) | 75 | 56 | 66 | 45 | 43 | 34 | 39 | 34 | 45 | 47 | 53 | 42 | 24 | > 500 | > 500 | 421 |
| | Continuous moldability (number of shots until stain formation) | > 75 | > 56 | > 66 | > 45 | > 43 | > 34 | > 39 | > 34 | > 45 | > 47 | > 53 | > 42 | > 24 | > 500 | > 500 | 421 |
| | Flame retardance | A | A | A | A | B | B | C | C | C | C | C | C | A | A | C | C |

It is seen from the Tables above that in Examples 1 to 16 where those used as the components (A) to (E) all are within the scope of the present invention, all of the evaluation items 1) to 4) are satisfied and fall in a practical range.
In the composition of the present invention, when a trifunctional epoxy resin for comparison is used in place of the bifunctional epoxy resin as the component (A) within the scope of the present invention, as seen in Comparative Examples 27 and 28, flame retardance and flowability cannot be ensured.
In the composition of the present invention, when a curing accelerator for comparison is used in place of the component (C) within the scope of the present invention, even if the mold release agent is used in a small amount compared with Examples, as seen in Comparative Examples 13, 15, 17 and 19 to 21, adhesiveness cannot be ensured. Also, as seen from Comparative Examples 1 to 9, even if the curing accelerator is a product for comparison, the continuous moldability is ensured when the content of the mold release agent is increased, but flowability and adhesiveness are not improved in the case of using the curing accelerator for comparison.
In the composition of the present invention, when a small amount of a mold release agent for comparison is used in place of the component (D) within the scope of the present invention, as seen in Comparative Example 25, continuous moldability cannot be ensured. Also, when the amount of the mold release agent for comparison is increased to improve the continuous moldability, flowability changes for the worse (Comparative Example 26).
Furthermore, it can be understood from Examples and Comparative Examples that the blending ratio of the component (D) is preferably from 0.1 to 0.8 mass% particularly in view of continuous moldability. In addition, there is a tendency that a large blending ratio of the component (D) causes stain formation and a small blending ratio allows sticking.

While the invention has been described in detail with reference to specific embodiments thereof, it will be apparent to one skilled in the art that various changes and modifications can be made therein without departing from the spirit and scope thereof.
Incidentally, the present application is based on Japanese Patent Application No. 2009-134899 filed on June 4, 2009, and the contents are incorporated herein by reference.
Also, all the references cited herein are incorporated as a whole.

According to the present invention, a resin composition for semiconductor encapsulation, which is excellent in flowability, adhesiveness to a polyimide material and continuous moldability, and a semiconductor device using the same can be provided. Also, according to the present invention, since high adhesiveness and good flame retardance are ensured, excellent reflow resistance is expected to be achieved.

## Claims

1. An epoxy resin composition for semiconductor encapsulation, which comprises the following components (A) to (E):
(A) a bifunctional epoxy resin,
(B) a curing agent,
(C) an imidazole compound represented by the formula (1): 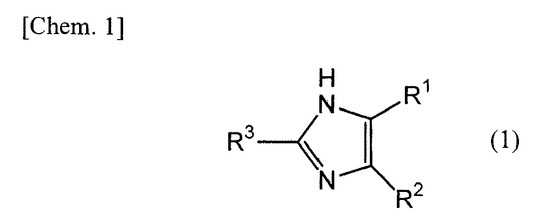
wherein R¹ and R² each independently represent an alkyl group or an alkylol group, in which at least one of R¹ and R² represents an alkylol group, and R³ represents an alkyl group or an aryl group,
(D) a linear saturated carboxylic acid having a number average molecular weight of 550 to 800, and
(E) an inorganic filler.

2. The epoxy resin composition for semiconductor encapsulation as claimed in claim 1, wherein the component (A) is a compound represented by the formula (2): 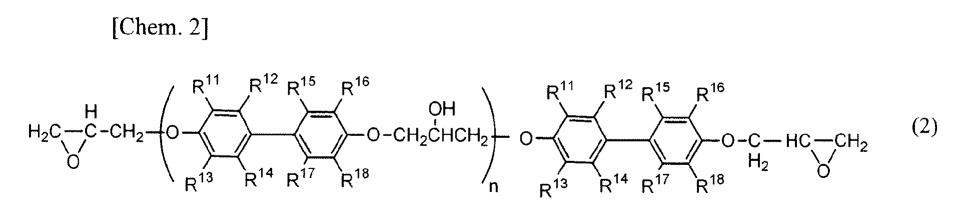 wherein R¹¹ to R¹⁸ each independently are selected from a hydrogen atom and a substituted or unsubstituted monovalent hydrocarbon group having a carbon number of 1 to 10, and n represents an integer of 0 to 3.

3. The epoxy resin composition for semiconductor encapsulation as claimed in claim 1 or 2, wherein the component (B) is a compound represented by the formula (3) or (4): 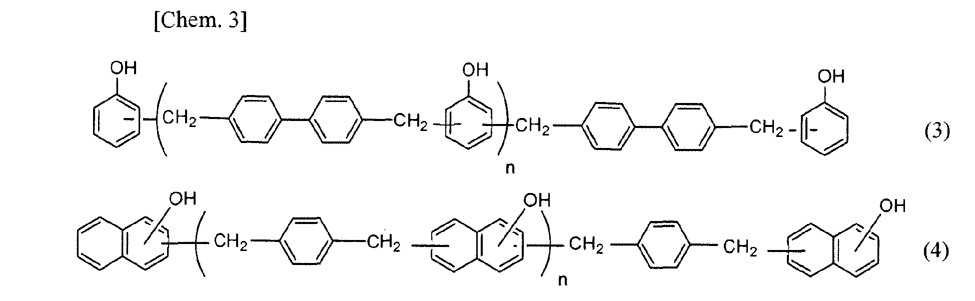 wherein each n independently represents an integer of 0 to 5.

4. The epoxy resin composition for semiconductor encapsulation as claimed in any one of claims 1 to 3, wherein the component (C) is 2-phenyl-4-methyl-5-hydroxymethylimidazole.

5. The epoxy resin composition for semiconductor encapsulation as claimed in any one of claims 1 to 4, wherein the content of the component (D) is from 0.05 to 1.5 mass% based on the epoxy resin composition.

6. The epoxy resin composition for semiconductor encapsulation as claimed in any one of claims 1 to 5, wherein the number average molecular weight of the component (D) is 600 to 800.

7. A semiconductor device obtained by encapsulating a semiconductor element with the epoxy resin composition for semiconductor encapsulation as claimed in any one of claims 1 to 6.
